(19) Europäisches Patentamt

European Patent Office

Office européen des brevets

(11) Numéro de publication: **0 354 106 B1**

(12) **FASCICULE DE BREVET EUROPEEN**

(45) Date de publication de fascicule du brevet: **05.01.94** (51) Int. Cl.⁵: **H04N 5/217**, H01L 27/14

(21) Numéro de dépôt: **89402153.4**

(22) Date de dépôt: **28.07.89**

(54) **Circuit d'élimination du bruit, intégré dans un détecteur d'images à l'état solide.**

(30) Priorité: **01.08.88 FR 8810375**

(43) Date de publication de la demande:
**07.02.90 Bulletin 90/06**

(45) Mention de la délivrance du brevet:
**05.01.94 Bulletin 94/01**

(84) Etats contractants désignés:
**DE GB NL**

(56) Documents cités:
**EP-A- 0 019 269**
**EP-A- 0 068 975**

**PATENT ABSTRACTS OF JAPAN, vol. 5, no. 186 (E-84)[858], 25 novembre 1981; & JP-A-56 111 382 (HITACHI SEISAKUSHO K.K.) 03-09-1981**

**XEROX DISCLOSURE JOURNAL, vol. 5, no. 5, septembre/novembre 1980, page 545; S. MARSHALL: "Using charge injection on CCD imaging chips"**

(73) Titulaire: **COMMISSARIAT A L'ENERGIE ATO-MIOUE**
**31/33, rue de la Fédération**
**F-75015 Paris Cédex 15(FR)**

(72) Inventeur: **Nicolas, Pierre**
**42 Route de Grenoble**
**F-38120 Saint Egreve(FR)**
Inventeur: **Pantigny, Philippe**
**4 Avenue Albert 1er de Belgique**
**F-38100 Grenoble(FR)**

(74) Mandataire: **Mongrédien, André et al**
**c/o BREVATOME**
**25, rue de Ponthieu**
**F-75008 Paris (FR)**

EP 0 354 106 B1

# Description

La présente invention concerne un système de détection d'informations sous forme de rayonnement électromagnétique et de lecture des informations détectées. Elle trouve notamment une application en imagerie infrarouge.

On sait que les systèmes d'imagerie infrarouge comprennent des moyens de photodétection d'informations sous forme de rayonnement infrarouge et des moyens de lecture des informations détectées. Les moyens de photodétection sont électriquement couplés aux moyens de lecture et la présente invention se rapporte plus particulièrement au couplage électrique de ces moyens de photodétection et de lecture.

On sait aussi que les moyens de photodétection infrarouge peuvent utiliser divers photodétecteurs tels que des détecteurs photovoltaïques, des photoconducteurs ou des détecteurs de type MIS (Métal Isolant Semi-conducteur). Ces détecteurs mettent en oeuvre la conversion de photons infrarouges en électrons ou en trous et utilisent à cet effet un substrat autorisant une détection intrinsèque ou extrinsèque des photons (voir les articles de G.A. WALTER et al. publiés dans "Laser focus/Electro-optics", (1) mars 1986, p. 108 à 118 et (2) avril 1986, p. 86 à 96). D'une manière générale, tous ces détecteurs peuvent être considérés comme des photogénérateurs de courant, qui sont sensibles aux photons de telle ou telle gamme de longueur d'onde.

Pour "lire" ces détecteurs, de nombreuses méthodes sont également disponibles, selon que l'on désire lire un unique photodétecteur, ou une barrette de photodétecteurs ou encore une mosaïque bidimensionnelle de photodétecteurs.

Selon le type de détecteur utilisé, ce détecteur peut être lu en courant, en tension ou en charge. De toute façon, toutes les techniques connues font appel à une conversion finale en tension de façon à disposer d'un signal sur une ligne de basse impédance satisfaisant les besoins de traitement de ce signal (visualisation, détection de seuils, d'objets, de signature spectrale, de vitesse, etc.).

Quelques unes des méthodes de lecture sont notamment évoquées dans l'article (3) de K. CHOW et al. intitulé " Hybrid infrared focal plane arrays" et publié dans IEEE Transactions on Electron Devices, Vol. ED 29, n° 1, janvier 1982, dans le document (4) M.A. KEENAN et al., R.A. BALLINGAL et al., T.W. RIDLER, Advanced infrared detectors and systems, IEE London, 3-5 june 1986, Conférence publication n° 263 et dans l'article (5) de M.R. KRUER et al., publié dans Optical Engineering, mars 1987, vol. 26, n° 3, p. 182 à 190.

L'un des problèmes majeurs associés à la détection infrarouge est celui de la lecture de forts courants fournis par les photodétecteurs. Les situations conduisant à de forts courants de détection ne sont pas rares. A titre d'exemple, on peut citer la détection à grande longueur d'onde, la détection sur un fond ambiant fortement émissif et la détection utilisant des photodétecteurs à température intermédiaire et disposant donc d'une forte composante de courant thermique. Par température intermédiaire, on entend une température de fonctionnement des photodétecteurs, telle que la composante de courant d'obscurité (courant thermique) de ces photodétecteurs ne soit pas négligeable devant la composante photonique.

Les composantes de courant trop élevées, et souvent non porteuses d'information utile, conduisent immanquablement à un problème de saturation des circuits de lecture. Pour résoudre ce problème, différentes solutions sont utilisables. On peut citer, par exemple dans le cas de l'utilisation d'un circuit DTC (Dispositif à Transfert de Charges) de lecture et de multiplexage, les solutions utilisant un couplage de grille (gate coupling) et les solutions utilisant un couplage de source et un traitement de signal au niveau du circuit de lecture, telles que "l'écrémage" (skimming) et/ou la partition (partitioning) voir l'article (3).

Cependant, ces techniques connues, qui nécessitent des dispositifs implantés dans le circuit de lecture, présentent des inconvénients. En particulier, on peut citer, pour le couplage de grille, la complexité de l'électronique nécessaire (préamplificateur plus fortes charges résistives - voir l'article (3) cité plus haut) ainsi que le problème de linéarité associé à ce mode de lecture. Ce problème de linéarité se pose ensuite au niveau de l'électronique de traitement de signal à la sortie du dispositif de lecture. Dans le cas d'une injection directe en couplage de source (source coupling) dans un circuit réalisé sur un substrat de silicium, les solutions de type "écrémage" et partition ne permettent pas de supprimer complètement la saturation du circuit de silicium puisque la totalité des charges (charges correspondant au fond ambiant et charges correspondant au signal) doivent être injectées dans le circuit de lecture en silicium (voir l'article (3) cité plus haut).

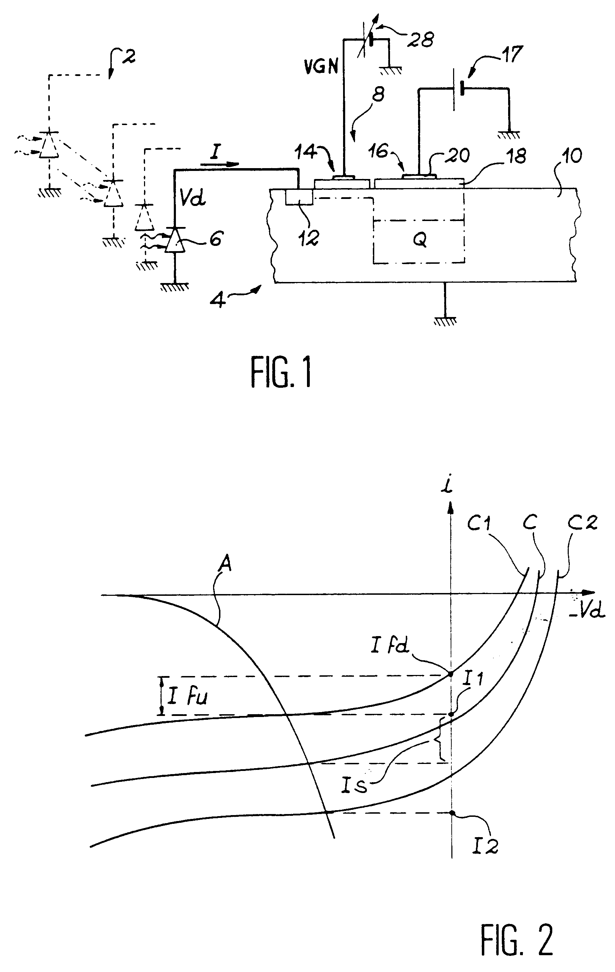

Ce problème de saturation va maintenant être illustré par un exemple limité à un dispositif de détection infrarouge et à un circuit de lecture réalisé sur un substrat en silicium. Le système correspondant, qui est connu par l'article (3), est représenté sur la figure 1 de façon schématique et partielle. Ce système comprend donc des moyens 2 de photodétection d'informations sous forme de rayonnement infrarouge et des moyens 4 de lecture des informations ainsi détectées. Ces moyens de lecture 4 sont électriquement couplés aux moyens de photodétection 2.

Ces moyens de photodétection comprennent au moins un photodétecteur infrarouge de type photovoltaïque 6, c'est-à-dire une photodiode infrarouge par exemple de type N sur P. Les moyens de lecture 4 comprennent un étage d'entrée 8 constitué par un transistor MOS à canal N. Ce transistor est réalisé sur un substrat 10 de silicium de type P et comprend une source 12 (de type N), une grille 14 et une capacité de stockage 16 jouant le rôle de drain virtuel. Cette capacité 16 comprend une couche de silice 18 constituant un diélectrique et déposée à la surface du substrat 10. Cette couche 18 est surmontée d'une électrode 20 portée, au moyen d'une source appropriée 17, à un potentiel positif par rapport à la masse. Le substrat 10 est, quant à lui, mis à la masse. Le photodétecteur 6 est couplé en injection directe (source coupling) au transistor 8 : la cathode de la photodiode constituant ce photodétecteur 6 est mise à la masse et son anode est électriquement reliée à la source 12 du transistor 8.

Le fait de porter l'électrode 20 de la capacité 16 à un potentiel positif permet de faire disparaître les porteurs majoritaires (trous) du substrat 10 sous la couche de silice 18.

Lorsque le photodétecteur 6 reçoit un rayonnement infrarouge, il envoie un courant d'électrons I à la source 12 du transistor de polarisation 8 et au bout d'un temps d'intégration ti, une charge Q égale à I.ti se trouve accumulée sous la capacité de stockage 16. Cette charge est ensuite convertie en tension par tout moyen approprié (non représenté). Une telle tension est utilisable sur une ligne de basse impédance.

Bien entendu, comme on l'a schématisé sur la figure 1, les moyens de photodétection 2 peuvent comprendre une pluralité de photodiodes 6 au lieu d'une seule. Dans ce cas, chaque photodiode est couplée en injection directe à un transistor de polarisation du type du transistor 8. Tous les transistors de polarisation, constituant alors l'étage d'entrée des moyens de lecture associés à la pluralité de photodiodes, peuvent être intégrés sur le substrat 10 de silicium de type P et la source 17 peut être commune à tous ces transistors.

En revenant au fonctionnement du système décrit en référence à la figure 1, on a représenté sur la figure 2 la caractéristique A du transistor de polarisation 8, ou transistor de lecture, en régime de saturation. On suppose que les utilisateurs du système représenté sur la figure 1 ne s'intéressent qu'au signal fourni par chaque photodétecteur 6 dans une certaine gamme de flux de photons infrarouges : le flux $\phi$ de photons infrarouges reçu par le photodétecteur 6 peut varier entre une valeur minimale $\phi 1$ et une valeur maximale $\phi 2$. Sur la figure 2, on a également représenté la caractéristique C1 du photodétecteur 6 exposé au flux minimum $\phi 1$ et la caractéristique C2 de ce photodétecteur 6 exposé au flux maximum $\phi 2$.

Les intensités i de courant sont portées en ordonnées tandis qu'on a porté en abscisses l'opposé du potentiel Vd de l'anode du photodétecteur 6.

Au cours du temps, la caractéristique C de ce photodétecteur 6, exposé au flux $\phi$, varie entre les caractéristiques C1 et C2.

Le photodétecteur 6, soumis au flux $\phi 1$ (respectivement $\phi 2$), engendre un courant I1 (respectivement I2) qui constitue l'ordonnée du point d'intersection de la caractéristique A et de la caractéristique C1 (respectivement C2) ou point de fonctionnement statique du système soumis au flux $\phi 1$ (respectivement $\phi 2$).

Lorsque le photodétecteur 6 est soumis au flux $\phi 1$ par exemple, il engendre donc le courant I1 au point de fonctionnement statique correspondant et ce courant, qui est un courant d'électrons dans le cas considéré, est injecté dans le transistor de polarisation 8. Au bout du temps d'intégration ti, une charge Q1 égale à I1.ti se trouve stockée sous la capacité 16. Cette charge est une image du flux $\phi 1$ vu par le photodétecteur durant le temps ti. Cette capacité 16 joue donc bien le rôle de drain virtuel pour le transistor 8.

La figure 2 met en évidence le fait que le courant total I qui est injecté dans le transistor 8 a diverses composantes, à savoir :
- une composante non porteuse d'information, qui est décomposable en :
  . une composante notée Ifd, qui correspond à l'intersection de la caractéristique C1 et de l'axe des ordonnées ; cette composante Ifd est imposée par exemple par le fond ambiant qui est dû, entre autres, au flux minimum $\phi 1$,
  . une autre composante notée Ifu est liée à la température de fonctionnement du photodétecteur (courant de saturation) ainsi qu'au courant de fuite imposé par l'impédance de fuite du photodétecteur ; Ifu est en fait égal à I1 diminué de Ifd ;
- une composante porteuse de l'information recherchée (composante utile), qui est notée Is et qui est égale, pour le flux $\phi$, à l'ordonnée de l'intersection des caractéristiques A et C, diminuée de I1.

On constate donc que Is est susceptible de varier entre 0 et I2 - I1. Par ailleurs, le courant total injecté I est donc la somme de Ifd, Ifu et Is. C'est ce courant I qui conditionne le temps d'intégration maximal $ti_{max}$ tolérable pour ne pas saturer la capacité jouant le rôle de drain virtuel dans l'étage d'entrée des moyens de lecture 4.

La présente invention vise à résoudre le problème de saturation évoqué plus haut en n'envoyant que l'information utile aux moyens de lecture d'un système d'imagerie infrarouge et plus généralement d'un système de détection d'informations sous forme de rayonnement électromagnétique et de lecture des informations détectées. Ainsi, dans l'exemple illustré par la figure 1, la présente invention résout le problème de n'injecter que la composante utile Is sous la capacité de stockage 16.

A cet effet, conformément à la présente invention, la composante inutile du courant (composante non porteuse d'information) est dérivée avant l'injection de ce courant dans les moyens de lecture, et ce, sans dégrader l'impédance apparente du ou des photodétecteurs, impédance qui conditionne le bon fonctionnement du système.

On connaît par le document EP-A-0 019 269 un procédé et un agencement commutateur destiné á séparer le signal de fond thermique d'un détecteur à infrarouge, du signal utile.

De façon précise, la présente invention a pour objet un système de détection d'informations sous forme de rayonnement électromagnétique et de lecture des informations détectées, ce système comprenant :

- des moyens de photodétection des informations, ces moyens de photodétection comportant N photodétecteurs, chaque photodétecteur étant apte à fournir un courant comportant une composante porteuse d'information et une composante non-porteuse d'information, N étant un nombre entier au moins égal à 1, et

- des moyens de lecture des informations ainsi détectées, qui utilisent pour ce faire le courant fourni par chaque photodétecteur,

système caractérisé en ce qu'il comprend en outre N autres moyens réglables qui sont respectivement associés aux N photodétecteurs, chaque autre moyen réglable étant apte à soustraire un courant d'intensité réglable du courant fourni par le photodétecteur associé, avant l'utilisation de ce dernier courant par les moyens de lecture, de façon à soustraire la comprenante non porteuse d'information du courant fourni par le photodetécteur associé.

A l'aide d'un réglage approprié de chaque autre moyen réglable, on voit que l'on peut soustraire du courant fourni par le photodétecteur associé à cet autre moyen réglable la composante non porteuse d'information avant l'utilisation, par les moyens de lecture, du courant fourni par ce photodétecteur.

Selon un mode de réalisation particulier du système objet de l'invention, N est supérieur à 1 et chaque autre moyen réglable est en outre apte à mémoriser, lorsque les photodétecteurs sont soumis à un même rayonnement électromagnétique de référence, une information électrique de correction, liée à ce rayonnement de référence et permettant à chacun des moyens réglables, lorsque ceux-ci sont soumis aux informations sous forme de rayonnement électromagnétique, d'engendrer un courant électrique de correction qui est fonction de l'information électrique de correction mémorisée et qui est soustrait du courant fourni par le photodétecteur tant que celui-ci reçoit les informations sous forme de rayonnement électromagnétique et que l'information électrique de correction reste mémorisée.

Comme on le verra mieux par la suite, ce mode de réalisation particulier permet de résoudre, d'une manière analogique, le problème de suppression du bruit connu sous le nom de "bruit spatial fixe" (fixed pattern noise) qui est engendré par les N photodétecteurs, alors que les techniques connues nécessitent un traitement numérique compliqué des signaux fournis par le système (notamment lorsqu'il s'agit d'un système d'imagerie infrarouge).

Dans une réalisation particulière du système objet de l'invention, chaque autre moyen réglable comporte un générateur réglable de courant de porteurs de charge de type opposé à celui des porteurs de charge du courant fourni par le photodétecteur associé, l'intensité du courant fourni par ce générateur réglable étant donc de signe contraire à celle du courant fourni par ce photodétecteur associé.

Ceci permet notamment de régler chaque générateur de courant de telle façon que la valeur absolue de l'intensité du courant qu'il est capable de fournir soit égale à la valeur absolue de l'intensité de ladite composante non porteuse d'information, afin de soustraire cette dernière du courant fourni par le photodétecteur considéré.

De préférence, chaque générateur réglable de courant comprend un transistor qui possède une électrode de commande, qui est monté en parallèle avec le photodétecteur associé et qui est capable de fournir ledit courant de porteurs de charge de type opposé, ce transistor étant réglé en portant son electrode de commande à un potentiel approprié.

En effet, la commande d'un transistor peut être réalisée par l'intermédiaire d'un seul conducteur électrique et il est donc plus facile de commander un transistor que, par exemple, un phototransistor ou une photodiode dont la commande nécessite l'utilisation de lumière.

Dans la présente invention, le transistor peut être un transistor MOS, ladite électrode de commande étant alors l'électrode de grille de ce transistor.

Dans ce cas, et en considérant le mode de réalisation particulier du système objet de l'invention permettant la suppression du "bruit spatial fixe" et mentionné plus haut, les moyens de lecture comportant un étage d'entrée qui reçoit le courant fourni par chaque photodétecteur, l'électrode de grille du transistor MOS peut être reliée à cet étage d'entrée par l'intermédiaire d'un commutateur, ce qui permet à la capacité de grille du transistor MOS de mémoriser l'information électrique de correction lorsque le commutateur est fermé et que le photodétecteur associé est soumis au rayonnement électromagnétique de référence.

Ledit commutateur peut être commandé par un signal électrique périodique permettant la fermeture périodique de ce commutateur.

Ledit commutateur peut être par exemple réalisé au moyen d'un transistor : le système objet de l'invention peut comprendre en outre N autres transistors qui sont respectivement associés aux photodétecteurs, chaque autre transistor étant monté de façon à former le commutateur qui est associé au photodétecteur correspondant à cet autre transistor.

Enfin, comme on l'a déjà mentionné plus haut, lesdites informations peuvent être sous la forme d'un rayonnement infrarouge. Cependant la présente invention n'est pas limitée à un tel rayonnement et peut être adaptée à la détection d'un rayonnement visible, ultraviolet, X ou gamma par exemple, comme on le verra par la suite.

La présente invention sera mieux comprise à la lecture de la description qui suit d'exemples de réalisation donnés à titre purement indicatif et nullement limitatif en référence aux dessins annexés sur lesquels :

- la figure 1 est une vue schématique et partielle d'un système connu de détection d'informations et de lecture des informations détectées et a déjà été décrite,
- la figure 2 représente des caractéristiques de ce système et a déjà été décrite,
- la figure 3 est une vue schématique et partielle d'un mode de réalisation particulier du système objet de l'invention,
- la figure 4 illustre l'intérêt du système représenté sur la figure 3 au moyen de caractéristiques courant-tension, et
- la figure 5 est une vue schématique et partielle d'un autre système conforme à l'invention.

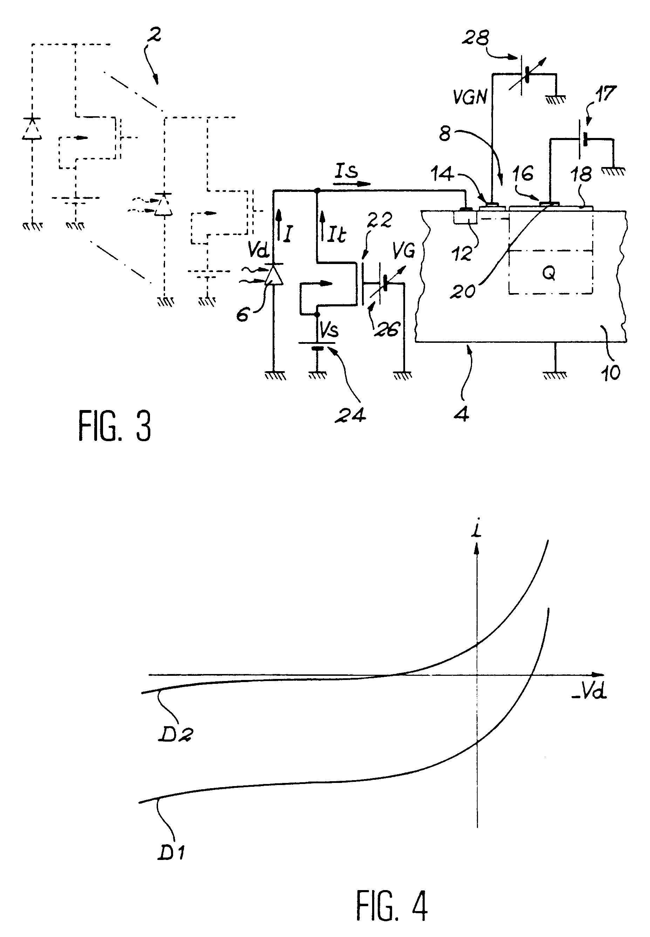

Sur la figure 3, on a représenté schématiquement et partiellement un mode de réalisation particulier du système objet de l'invention. Le système représenté sur la figure 3 résulte d'une modification du système représenté sur la figure 1, en vue de n'injecter que la composante porteuse d'informations Is sous la capacité de stockage 16. Cette modification permet de dériver la composante non porteuse d'informations du courant I fourni par chaque photodétecteur 6 avant l'injection de ce courant dans l'étage d'entrée 8 des moyens de lecture 4, sans dégradation de l'impédance apparente du ou des photodétecteurs.

Cette modification est la suivante : à chaque photodétecteur 6 est associé un transistor 22 de type MOS, à canal P, qui est monté en parallèle avec le photodétecteur associé. Le drain du transistor 22 est électriquement relié à l'anode de la diode de détection associée 6. La source du transistor 22 est portée à un potentiel positif fixe VS grâce à une source appropriée 24. La grille du transistor 22 est portée à un potentiel positif VG réglable grace à une source réglable appropriée 26. On voit également sur la figure 3 la prise de contact du substrat du transistor 22, substrat qui est porté également au potentiel VS. Ce transistor 22 est utilisé en régime saturé en commandant sa tension grille-source, soit VG - VS, en réglant à cet effet la source 26. Le transistor 22 se comporte donc comme un générateur de courant commandé par VG - VS et présente une très forte impédance dynamique (fixée par la tension d'Eurly du transistor 22), qui est égale à l'impédance drain-source du transistor 22 (typiquement quelques gigaohms en régime de saturation).

Le transistor 22, qui est en parallèle avec le photodétecteur 6, ne dégrade donc pas ou peu l'impédance dynamique de ce photodétecteur 6 lorsque cette dernière impédance n'excède pas ces quelques gigaohms.

On voit également sur la figure 3 que la grille 14 du transistor 8 est portée à un potentiel positif VGN réglable grâce à une source réglable appropriée 28, en vue de pouvoir régler le point de fonctionnement du système (ceci étant d'ailleurs également vrai pour le système de la figure 1).

Lorsqu'il y a une pluralité de photodétecteurs, on peut utiliser une seule source 24 et une seule source 26 pour tous les transistors 22 associés à ces photodétecteurs et une seule source 28 pour tous les transistors 8 également associés à ces photodétecteurs.

Bien entendu, au lieu d'utiliser une source 26 réglable et une source 24 fournissant un potentiel VS fixe, on pourrait utiliser une source 24 réglable et une source 26 fournissant un potentiel VG fixe.

Par ailleurs, l'adjonction de chaque transistor 22 au système représenté sur la figure 1 peut être réalisée en utilisant une technologie MOS à canaux complémentaires (technologie CMOS) : sur une plaque de silicium de type P est réalisé chaque transistor 8 et sur cette plaque on réalise aussi des caissons dont le nombre est égal à celui des photodétecteurs 6, et sur chaque caisson, on forme un substrat de type N ; sur chaque substrat ainsi formé, on réalise un transistor 22. Bien entendu, au lieu d'utiliser une technologie monolithique, on pourrait réaliser chaque transistor 8 sur un même substrat et chaque transistor 22 sur un même substrat différent du précédent et réaliser ensuite les interconnexions nécessaires.

Le fonctionnement du système représenté sur la figure 3 est le suivant : le transistor 22 de type MOS à canal P se comporte comme un générateur de courant de trous It. Ces trous se recombinent aux électrons fournis par la diode détectrice 6. Le courant résultant Is injecté dans le transistor 8 de type MOS à canal N est donc la somme algébrique de ces deux courants dont les intensités I et It ont des signes opposés. On peut donc ajuster cette somme en agissant sur la source réglable 26, pour n'injecter dans le transistor 8 que la composante Is porteuse d'informations. A cet effet, on peut par exemple placer le système dans l'obscurité (correspondant à $\phi 1$) et régler VG jusqu'à annuler la composante non porteuse d'informations Ifd + Ifu, It étant alors égal à l'opposé de cette composante non porteuse d'information.

On remarquera que le montage du transistor 22 de type MOS à canal P permet de rendre ce dernier insensible aux variations de son potentiel de drain (régime saturé), ce potentiel évoluant légèrement en fonction du flux $\phi$ reçu par la diode détectrice 6.

Sur la figure 4, on a représenté la caractéristique courant (i)-tension (-Vd) de l'ensemble photodétecteur 6-transistor 22, pour un flux de rayonnement infrarouge $\phi$ donné, lorsque VG est égal à VS (courant nul dans le transistor 22). Cette caractéristique est notée D1 sur la figure 4. Sur cette figure, on a également représenté la caractéristique de l'ensemble en question, pour le même flux $\phi$, mais lorsque le potentiel VG est inférieur à V. Cette dernière caractéristique est notée D2 sur la figure 4. On voit donc sur cette figure 4 l'effet du transistor 22. Ce transistor 22, convenablement réglé, permet donc un véritable "écrémage" en courant qui résout le problème de saturation posé plus haut.

Le système représenté sur la figure 3 a deux avantages très importants :

- D'une part, la totalité de la dynamique de stockage sous la capacité 16 n'est utilisée que pour la composante porteuse d'informations, ce qui augmente la sensibilité du système. Ce dernier a une meilleure réponse en volts par photon infrarouge reçu.
- D'autre part, on peut accroître, à capacité de stockage donnée, le temps d'intégration du système (puisque le courant total est diminué), ce qui a un effet immédiat sur le bruit de ce système. En effet, on sait que le temps d'intégration ti fixe la bande passante électronique du système à une bande passante idéale de fréquence de coupure fc = 0,5/ti.

Etant donné que le transistor 22 fonctionne en parallèle avec le photodétecteur 6, les densités spectrales de courant de bruit de ces deux composants s'ajoutent quadratiquement et sont injectées dans les moyens de lecture. Dans le cas où la composante non porteuse d'information est importante par rapport à la composante porteuse d'information, on doit s'attendre à une augmentation de densité spectrale de courant de bruit de l'ordre de $2^{1/2}$ si les bruits du transistor 22 et de la photodiode 6 sont identiques. Le rapport signal/bruit en sortie du système étant proportionnel à $ti^{1/2}$, cette dégradation se trouve compensée en doublant seulement le temps ti initial (sans écrémage en courant). L'écrémage en courant permet potentiellement une augmentation beaucoup plus importante de ti et le système utilisant cet écrémage en courant est donc bien meilleur que le système de l'art antérieur (figure 1).

L'écrémage en courant selon la présente invention a été exposé dans le cas particulier d'un détecteur infrarouge de type photovoltaïque N sur P "lu" en injection directe (couplage de source) par un transistor MOS à canal N. L'invention est cependant très générale et peut être adaptée à de nombreux types de détecteurs et de circuits de lecture. A titre d'exemple, on peut citer :

a) pour les détecteurs :
- les détecteurs photovoltaïques du type homojonction ou hétérojonction,
- les détecteurs photoconducteurs intrinsèques ou extrinsèques,
- les détecteurs de type CID (Charge Injection Device) ou XCED (Extrinsic Charge Extraction Device) ou IBC (Impurity Band Conduction) - voir l'article (1), les détecteurs IBC étant également connus sous l'appellation de détecteurs BIB ou BIBIB,
- les détecteurs de type phototransistor,

b) pour les circuits de lecture :
- les circuits de type DTC (CCD dans les publications en langue anglaise, pour Charge Coupled Devices) - voir l'article (3),
- les circuits de type commutateur MOS - voir document (4),
- les préamplificateurs courant-tension ou charge-tension,
- les circuits de lecture du type DRO (Direct Read Out) - voir le document (6) Preliminary measurement of very low dark currents in MLA/SWIR HgCdTe/DRO arrays, B.T. YANG, SBCR IR Technology workshop, August 13-14 1985 at NASA/Ames.

Par ailleurs, l'écrémage en courant a été décrit dans le cas de la détection infrarouge mais son principe reste valable pour l'ensemble de la détection photonique, quel que soit le domaine spectral (visible, ultraviolet, X ou gamma ...). Pour la détection d'un rayonnement X ou gamma, il suffit de coupler, à un photoscintillateur apte à détecter ce rayonnement X ou gamma, un photodétecteur approprié qui fournira le courant I.

Enfin, la fonction de générateur de courant réalisée par le transistor 22 pourrait être assurée par d'autres dispositifs. On pourrait par exemple réaliser cette fonction en utilisant un phototransistor ou une photodiode pour rayonnement visible ou autre. Cependant, le transistor (de type MOS ou d'un autre type) est un moyen préféré pour réaliser cette fonction puisque sa commande peut être assurée électriquement à l'aide d'un seul conducteur électrique (pour le réglage de VG avec VS fixé ou, en variante, pour le réglage de VS avec VG fixé, comme on l'a déjà indiqué plus haut).

Un transistor est également très bien adapté à la réalisation de structures de type barrette ou mosaïque puisque la commande électrique de l'écrémage en courant peut être commune à tous les points d'une telle barrette ou d'une telle mosaïque.

On notera aussi que la réalisation de l'invention met en oeuvre des moyens classiques de conception, de réalisation et d'interconnexion de circuits intégrés.

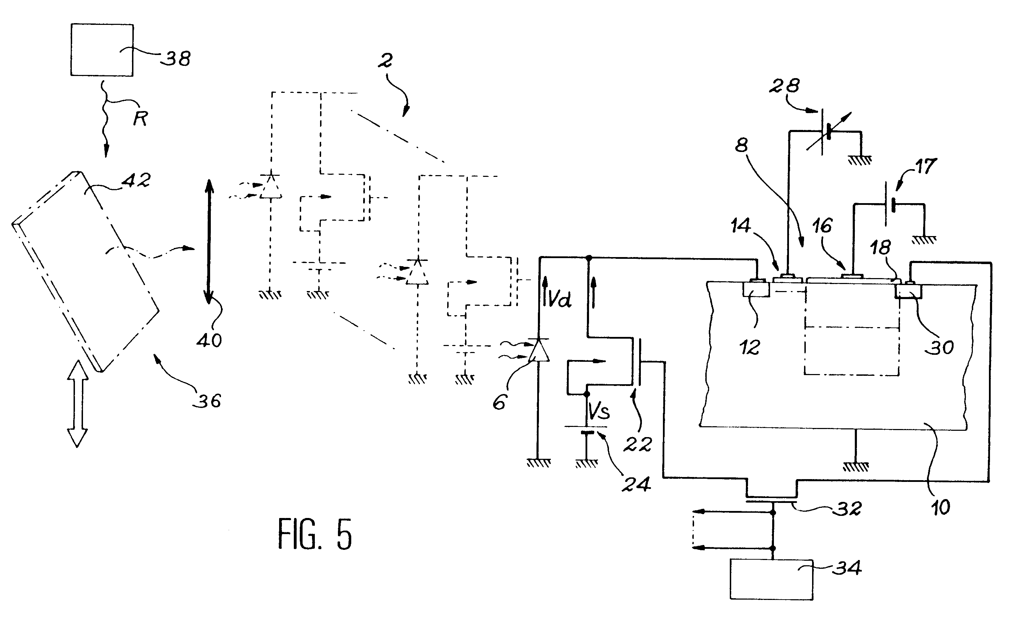

Sur la figure 5, on a représenté schématiquement et partiellement un autre mode de réalisation particulier du système objet de l'invention. Le système représenté sur la figure 5 permet une auto-calibration d'une mosaïque ou d'une barrette de photodétecteurs 2 qui sont " lus" en couplage de source par un circuit en silicium (voir figure 3).

Dans les dispositifs de détection infrarouge du type barrette ou mosaïque, on sait que l'un des problèmes à résoudre est la dispersion de comportement des différents photodétecteurs. Du fait des imperfections inévitables de la technologie de fabrication, les photodétecteurs éclairés par un flux de photons uniforme fournissent des courants différents. Cette dispersion induit un bruit connu sous le nom de "bruit spatial fixe" (fixed pattern noise) qui est corrigible par un étalonnage de l'imageur.

Une méthode d'étalonnage connue consiste à faire une prise de vue sous un éclairement servant de référence de correction, à mémoriser le signal de chacun des points élémentaires (photodétecteurs) et à soustraire ce signal du signal fourni par le photodétecteur considéré, lors d'une prise de vue. Pour ce faire, le signal de référence est numérisé en sortie de l'imageur et stocké sous forme numérique puis soustrait numériquement au signal également numérisé qui est fourni par chaque photodétecteur lors des prises de vue.

La présente invention permet d'envisager une structure élémentaire dotée de cette fonction de correction, non plus sous forme numérique mais sous forme analogique.

La figure 5 illustre schématiquement et partiellement un système d'imagerie infrarouge doté d'une telle fonction de correction (et même d'auto-correction) analogique. Le système représenté sur la figure 5 résulte d'une modification de celui qui est représenté sur la figure 3 : la grille de chaque transistor 22 est électriquement reliée, non plus à une source 26, mais à une zone 30 de type N implantée dans le substrat 10 de type P et située à proximité de la capacité de stockage 16 correspondant à ce transistor 22. La couche 30 est un moyen (dans le cas présent une prise de contact) permettant la lecture du potentiel de surface sous la couche 18. La liaison entre la grille du transistor 22 et la zone 30 associée se fait par l'intermédiaire d'un interrupteur par exemple constitué par un transistor 32 de type MOS, ce qui permet de porter la grille du transistor 22 au même potentiel que la zone 30 lorsque l'interrupteur en question est fermé. La fermeture ou l'ouverture de cet interrupteur est commandée par un signal pulsé. A cet effet, la source du transistor 32 est électriquement reliée à la grille du transistor 22 et le drain du transistor 32 est électriquement relié à la zone 30. Bien entendu, ces connexions de source et de drain du transistor 32 peuvent être inversées. De plus, la grille du transistor 32 est reliée à une source de tension 34 permettant de porter périodiquement la grille du transistor 32 à un potentiel permettant la fermeture de l'interrupteur, ce dernier étant ouvert le reste du temps.

La même source 34 peut être utilisée pour commander tous les transistors 32 (qui sont respectivement associés aux photodiodes 6).

En outre, le système représenté sur la figure 5 comprend des moyens 36 permettant d'envoyer un même rayonnement infrarouge de référence R sur tous les photodétecteurs 6. Ces moyens 36 comprennent par exemple une source infrarouge de référence 38 (homogène en température) dont le rayonnement est envoyé, à travers l'optique 40 du système, sur tous les photodétecteurs 6, par l'intermédiaire d'un réflecteur de rayonnement infrarouge 42 escamotable. Ainsi, lorsque ce réflecteur 42 est placé devant l'optique 40, le rayonnement de référence est envoyé sur tous les photodétecteurs 6 et lorsque le réflecteur 42 est escamoté, c'est au contraire le rayonnement infrarouge que l'on veut détecter qui atteint tous ces photodétecteurs.

Dans le cas où le système est destiné à l'étude d'un rayonnement visible, X ou gamma, on remplace les moyens 36 par des moyens escamotables de production de rayonnement respectivement visible, X ou gamma.

Le fonctionnement du système représenté sur la figure 5 se décompose en deux phases, à savoir une phase d'initialisation pendant laquelle les photodétecteurs reçoivent le flux de photons de référence et une phase de prise de vue pendant laquelle ils reçoivent le rayonnement à étudier.

Dans la phase d'initialisation pendant laquelle les photodétecteurs reçoivent le flux de photons de référence (le miroir 42 étant en position non-escamotée), on ferme chaque interrupteur 32, chaque transistor 8 étant normalement polarisé (c'est-à-dire que le choix du point de fonctionnement du système a été fait préalablement) et chaque capacité de stockage 16 initialisée classiquement (c'est-à-dire portée à son potentiel positif nominal). Quel que soit l'état initial du potentiel de la grille d'un transistor 22, cette grille va alors s'équilibrer à un potentiel qui permet l'annulation du courant dans le transistor 8 de lecture correspondant. On obtient donc l'état final recherché, à savoir un écrémage en courant, et ceci de façon automatique le courant de référence de chaque photodiode de détection 6 est annulé par le courant opposé fourni par le transistor 22 de type MOS à canal P correspondant à cette photodiode.

Dans la phase de prise de vue, chaque interrupteur 32 étant à nouveau ouvert, la capacité de la grille du transistor 22 correspondant conserve en mémoire le potentiel acquis pendant la phase d'initialisation.

Donc, lors de cette phase de prise de vue, seule une augmentation du courant du photodétecteur associé, porteuse de l'information utile, est injectée dans le transistor 8 correspondant et "mesurée" dans la capacité de stockage 16 de ce dernier.

En pratique, dans la phase de prise de vue, la capacité de la grille du transistor 22 va perdre progressivement son information de potentiel, stockée pendant la phase d'initialisation, avec une constante de temps qui est généralement d'une valeur très supérieure à la période de prise d'image de référence.

On voit donc que l'adjonction d'un petit nombre de composants (référencés 22, 32), intégrables au circuit de lecture de chaque point élémentaire de l'imageur multidétecteurs représenté sur la figure 5, confère à cet imageur deux nouvelles fonctions très importantes, à savoir :

- la fonction de suppression de la composante de courant non porteuse d'information (courant de décalage ou d'"offset"), et
- la fonction d'annulation du bruit spatial fixe des photodétecteurs.

Par l'intermédiaire de la seule commande du transistor 32, on assure donc l'auto-correction du système.

## Revendications

1. Système de détection d'informations sous forme de rayonnement électromagnétique et de lecture des informations détectées, ce système comprenant :
   - des moyens (2) de photodétection des informations, ces moyens de photodétection comportant N photodétecteurs (6), chaque photodétecteur étant apte à fournir un courant comportant une composante porteuse d'information et une composante non-porteuse d'information, N étant un nombre entier au moins égal à 1, et
   - des moyens (4) de lecture des informations ainsi détectées, qui utilisent pour ce faire le courant fourni par chaque photodétecteur (6),
   
   système caractérisé en ce qu'il comprend en outre N autres moyens réglables (22) qui sont respectivement associés aux N photodétecteurs, chaque autre moyen réglable étant apte à soustraire un courant d'intensité réglable du courant fourni par le photodétecteur associé, avant l'utilisation de ce dernier courant par les moyens de lecture (4), de façon à soustraire la comprenante non porteuse d'information du courant fourni par le photodétecteur associé.

2. Système selon la revendication 1, caractérisé en ce que N est supérieur à 1 et en ce que chaque autre moyen réglable (22) est en outre apte à mémoriser, lorsque les photodétecteurs (6) sont soumis à un même rayonnement électromagnétique de référence, une information électrique de correction, liée à ce rayonnement de référence et permettant à chacun des moyens réglables, lorsque ceux-ci sont soumis aux informations sous forme de rayonnement électromagnétique, d'engendrer un courant électrique de correction qui est fonction de l'information électrique de correction mémorisée et qui est soustrait du courant fourni par le photodétecteur tant que celui-ci reçoit les informations sous forme de rayonnement électromagnétique et que l'information électrique de correction reste mémorisée.

3. Système selon l'une quelconque des revendications 1 et 2, caractérisé en ce que chaque autre moyen réglable comporte un générateur réglable (22) de courant de porteurs de charge de type opposé à celui des porteurs de charge du courant fourni par le photodétecteur associé, l'intensité du courant fourni par ce générateur réglable étant donc de signe contraire à celle du courant fourni par ce photodétecteur associé.

4. Système selon la revendication 3, caractérisé en ce que chaque générateur réglable de courant comprend un transistor (22) qui possède une électrode de commande, qui est monté en parallèle avec le photodétecteur associé et qui est capable de fournir ledit courant de porteurs de charge de type opposé, ce transistor étant réglé en portant son électrode de commande à un potentiel approprié.

5. Système selon la revendication 4, caractérisé en ce que le transistor (22) est un transistor MOS et en ce que l'électrode de commande est l'électrode de grille de ce transistor.

6. Système selon les revendications 2 et 5, caractérisé en ce que, les moyens de lecture comportant un étage d'entrée qui reçoit le courant fourni par chaque photodétecteur, l'électrode de grille du transistor MOS (22) est reliée à cet étage d'entrée par l'intermédiaire d'un commutateur (32), ce qui permet à la capacité de grille du transistor MOS de mémoriser l'information électrique de correction lorsque le commutateur est fermé et que le photodétecteur associé (6) est soumis au rayonnement électromagnétique de référence.

7. Système selon la revendication 6, caractérisé en ce que ledit commutateur (32) est commandé par un signal électrique périodique permettant la fermeture périodique de ce commutateur.

8. Système selon l'une quelconque des revendications 6 et 7, caractérisé en ce qu'il comprend en outre N autres transistors (32) qui sont respectivement associés aux photodétecteurs (6), chaque autre transistor étant monté de façon à former le commutateur qui est associé au photodétecteur correspondant à cet autre transistor.

9. Système selon l'une quelconque des revendications 1 à 8, caractérisé en ce que les informations sont sous la forme d'un rayonnement infrarouge.

**Claims**

1. System for the detection of information in the form of electromagnetic radiation and reading the detected information, said system comprising information photodetection means (2), which have N photodetectors (6), each photodetector being able to supply a current having an information carrier component and a component not carrying information, N being an integer at least equal to 1 and means (4) for reading the information detected in this way and using for this purpose the current supplied by each photodetector (6), characterized in that said system also comprises N other regulatable means (22) respectively associated with the N photodetectors, each other regulatable means being able to remove a current of regulatable intensity from the current supplied by the associated photodetector prior to the use of the latter current by the reading means (4), so as to remove the component not carrying information from the current supplied by the associated photodetector.

2. System according to claim 1, characterized in that N exceeds 1 and each other regulatable means (22) is also able to store, when the photodetectors (6) are exposed to the same reference electromagnetic radiation, and electric correction information, linked with said reference information and enabling each of the regulatable means, when they are subject to the information in the form of electromagnetic radiation, to produce an electric correction current, which is a function of the stored electric correction information and which is removed from the current supplied by the photodetector while the latter receives the information in the form of electromagnetic radiation and the electric correction information remains stored.

3. System according to either of the claims 1 and 2, characterized in that each other regulatable means has a regulatable current generator (22) for charge carriers of the type opposite to that of the charge carriers of the current supplied by the associated photodetector, the intensity of the current supplied by said regulatable generator consequently being of opposite sign to that of the current supplied by the associated photodetector.

4. System according to claim 3, characterized in that each regulatable current generator comprises a transistor (22) having a control electrode, which is connected in parallel with the associated photodetector and which is able to supply the opposite type of charge carrier current, said transistor being regulated by raising its control electrode to an appropriate potential.

5. System according to claim 4, characterized in that the transistor (22) is a MOS transistor and the control electrode is the gate electrode of said transistor.

6.    System according to claims 2 and 5, characterized in that the transistor is a MOS transistor and the control electrode is the gate electrode of said transistor and wherein the reading means have an input stage receiving the current supplied by each photodetector and the gate electrode of the MOS transistor (22) is connected to said input stage via a switch (32), which enables the gate capacity of the MOS transistor to store the electric correction information when the switch is closed and the associated photodetector (6) is subject to the reference electromagnetic radiation.

7.    System according to claim 6, characterized in that the switch (32) is controlled by a periodic electric signal permitting the periodic closing of said switch.

8.    System according to either of the claims 6 and 7, characterized in that said system also comprises N other transistors (32), which are respectively associated with the photodetectors (6), each other transistor being connected so as to form the switch associated with the photodetector corresponding to said other transistors.

9.    System according to any one of the claims 1 to 8, characterized in that the information is all in the form of infrared radiation.

**Patentansprüche**

1.    System zur Informationserfassung in der Form elektromagnetischer Strahlung und zum Lesen der erfaßten Informationen, wobei dieses System umfaßt:
Einrichtungen (2) zur Fotoerfassung von Informationen, wobei diese Einrichtungen zur Fotoerfassung N Fotodetektoren (6) umfassen, wobei jeder Fotodetektor einen Strom liefern kann, der eine Informationen tragende Komponente und eine keine Informationen tragende Komponente umfaßt, wobei N eine ganze Zahl wenigstens gleich 1 ist, und
Einrichtungen (4) zum Lesen der derart erfaßten Informationen, die, um dieses durchzuführen, den von jedem Fotodetektor (6) gelieferten Strom verwenden,
wobei das System **dadurch gekennzeichnet** ist, daß es ferner N weitere einstellbare Einrichtungen (22) umfaßt, die jeweils mit den N Fotodetektoren verbunden sind, wobei jede weitere einstellbare Einrichtung einen Strom einstellbarer Intensität von dem Strom, der von dem verbundenen Fotodetektor geliefert wird, vor der Verwendung dieses letzteren Stromes durch die Leseeinrichtungen (4) subtrahieren kann, derart, daß die keine Information tragende Komponente von dem Strom subtrahiert wird, der von dem verbundenen Fotodetektor geliefert wird.

2.    System nach Anspruch 1, **dadurch gekennzeichnet**, daß N größer als 1 ist und daß jede weitere, , einstellbare Einrichtung (22) ferner eine elektrische Korrekturinformation, wenn die Fotodetektoren (6) derselben elektromagnetischen Bezugsstrahlung ausgesetzt werden, speichern kann, die an diese Bezugsstrahlung gebunden ist und jeder der einstellbaren Einrichtungen erlauben, wenn sie Informationen in der Form elektromagnetischer Strahlung ausgesetzt sind, einen elektrischen Korrekturstrom zu erzeugen, der eine Funktion der gespeicherten, elektrischen Korrekturinformation ist und der von dem Strom, der von dem Fotodetektor geliefert wird, subtrahiert wird, soweit dieser die Informationen in der Form elektromagnetischer Strahlung erhält, und daß die elektrische Korrekturinformation gespeichert bleibt.

3.    System gemäß einem beliebigen der Ansprüche 1 und 2, **dadurch gekennzeichnet**, daß jede weitere, einstellbare Einrichtung einen einstellbaren Stromgenerator (22) von Ladungsträgern von dem Typ umfaßt, der zu dem von Ladungsträgern des Stromes entgegengesetzt ist, der von dem verbundenen Fotodetektor geliefert wird, wobei die von diesem einstellbaren Generator gelieferte Stromintensität daher dasumgekehrte Vorzeichen gegenüber demjenigen des Stromes ist, der von diesen verbunden Fotodetektor geliefert wird.

4.    System gemäß Anspruch 3, **dadurch gekennzeichnet**, daß jeder einstellbare Stromgenerator einen Transistor (22), der eine Steuerelektrode besitzt, umfaßt, der parallel zu dem verbundenen Fotodetektor geschaltet ist, und der den genannten Strom von Ladungsträgern der umgekehrten Art liefern kann, wobei dieser Transistor geregelt wird, indem seine Steuerelektrode an ein geeignetes Potential gelegt wird.

5.    System gemäß Anspruch 4, **dadurch gekennzeichnet**, daß der Transistor (22) ein MOS Transistor ist und daß die Steuerelektrode die Gate-Elektrode dieses Transistors ist.

6.    System gemäß den Ansprüchen 2 und 5, **dadurch gekennzeichnet**, daß die Leseeinrichtungen eine Eingangsstufe umfassen, die den von jedem Fotodetektor gelieferten Strom erhält, die Gate-Elektrode des MOS Transistors (22) mit dieser Eingangsstufe über einen Schalter (32) verbunden ist, was der Kapazität des Gate des MOS Transistors gestattet, die elektrische Korrekturinformation zu speichern, wenn der Schalter geschlossen ist und der verbundene Fotodetektor (6) elektromagnetischer Bezugsstrahlung ausgesetzt wird.

7. System gemäß Anspruch 6, **dadurch gekennzeichnet**, daß der genannte Schalter (32) durch ein elektrisches, periodisches Signal gesteuert wird, das das periodische Schließen dieses Schalters erlaubt.

8. System gemäß einem beliebigen der Ansprüche 6 und 7, **dadurch gekennzeichnet**, daß es ferner N weitere Transistoren (32) umfaßt, die jeweils mit den Fotodetektoren (6) verbunden sind, wobei jeder weitere Transistor derart geschaltet ist, daß er den Schalter bildet, der mit dem dem diesem weiteren Transistor entsprechenden Fotodetektor verbunden ist.

9. System gemäß einem beliebigen der Ansprüche 1 bis 8, **dadurch gekennzeichnet**, daß die Informationen in der Form einer Infrarotstrahlung sind.

FIG. 1

FIG. 2

FIG. 3

FIG. 4

FIG. 5